# EUROPEAN PATENT APPLICATION

(11) **EP 4 213 603 A1**
(43) Date of publication of application: **19.07.2023**
(21) Application number: 23151280.7
(22) Date of filing: 12.01.2023
(51) Int. Cl.: H05K 13/02, B65B 5/10

(54) **ARTICLE SUPPLY DEVICE**

(30) Priority: 14.01.2022 JP 2022004531
(71) Applicant: Panasonic Intellectual Property Management Co., Ltd., Osaka-shi, Osaka 540-6207 (JP)
(72) Inventor: YABUTA, Takuma, Osaka, 540-6207 (JP); KOUNO, Kazunori, Osaka, 540-6207 (JP); MATSUYAMA, Yoshinari, Osaka, 540-6207 (JP); UEDA, Takeshi, Osaka, 540-6207 (JP); EGUCHI, Masashi, Osaka, 540-6207 (JP)
(74) Representative: Eisenführ Speiser

(57) **Abstract**

An article supply device includes a holding unit that holds an article supply tray (104) having a storage section, an opening (603a) that is provided in the holding unit, a shutter (601) that is provided in the opening (603a), the shutter (601) being configured to be opened and closed, a drive unit that drives the shutter (601), and an article reception portion (102) that is provided below the opening. The holding unit holds the article supply tray (104) such that an article (701, 702) stored in the storage section of the article supply tray (104) is discharged to the article reception portion (102) through the opening when the shutter (601) is opened, and the drive unit controls opening and closing of the shutter (601) based on a size of the storage section storing therein the article (701, 702)in the article supply tray (104).

## Description

### BACKGROUND

### 1. Technical Field

The present disclosure relates to an article supply device.

### 2. Description of the Related Art

Conventionally, an automated system for using a robot or the like to store various articles in a storage (for example, a tray) to achieve an intended storage condition has been widely used.

Such a system performs an operation of storing an article in an appropriate position in a tray by using a belt conveyor or a conveyance robot, for example, to take out or to convey the article from a predetermined position.

For example, JP 2014-154586 A discloses a configuration of a filler device that transfers an electronic component from a first component storage where a plurality of electronic components are stored, to a second component storage where the plurality of electronic components are stored in a stacked on top of one another.

### SUMMARY

The present disclosure has been devised in view of the conventional circumstance described above, and an object of the present disclosure is to provide, in an automated system for achieving an intended article storage condition, an article supply device for supplying an article to be stored more efficiently so that efficiency of the operation is improved further.

An article supply device according to the present disclosure includes a holding unit that holds an article supply tray having a storage section, an opening that is provided in the holding unit, a shutter that is provided in the opening, the shutter being configured to be opened and closed, a drive unit that drives the shutter, and an article reception portion that is provided below the opening. The holding unit holds the article supply tray such that an article stored in the storage section of the article supply tray is discharged to the article reception portion through the opening when the shutter is opened, and the drive unit controls opening and closing of the shutter based on a size of the storage section storing therein the article in the article supply tray.

Conversions among a method, an apparatus, a system, a storage medium, a computer program, and the like of any combinations of the elements described above and the expressions used in the present disclosure also valid as aspects of the present disclosure.

According to the present disclosure, in an automated system for achieving an intended article storage condition, it is possible to supply an article to be stored more efficiently, and to further improve the operation efficiency.

### BRIEF DESCRIPTION OF THE DRAWINGS

Fig. 1 is a block diagram illustrating a configuration example of a tray making system according to a first exemplary embodiment;
Fig. 2 is a block diagram illustrating a configuration example of structures around a tray making unit according to the first exemplary embodiment;
Fig. 3 is a block diagram illustrating a configuration of a control system according to the first exemplary embodiment;
Fig. 4 is an external view illustrating a configuration example of an article supply tray according to the first exemplary embodiment;
Fig. 5 is an external view illustrating a configuration example of the article supply tray according to the first exemplary embodiment;
Fig. 6 is an external view illustrating a configuration example of a tray unit according to the first exemplary embodiment;
Fig. 7 is a schematic diagram for explaining a movement of supplying an article from the article supply tray according to the first exemplary embodiment;
Fig. 8 is a schematic diagram for explaining a movement of the tray unit according to the first exemplary embodiment;
Fig. 9 is a schematic diagram for explaining the sequence of inserting an article supply unit according to the first exemplary embodiment;
Fig. 10 is a schematic diagram for explaining a movement of the tray unit according to the first exemplary embodiment;
Fig. 11 is a schematic diagram illustrating a configuration example of the tray unit according to the first exemplary embodiment;
Fig. 12 is an external view illustrating a configuration example of a robot according to the first exemplary embodiment;
Fig. 13 is an external view for explaining an article storing operation according to the first exemplary embodiment;
Fig. 14 is a schematic diagram for explaining an article storing operation according to the first exemplary embodiment;
Fig. 15 is a schematic diagram for explaining an article storing operation according to the first exemplary embodiment;
Fig. 16 is an external view illustrating a configuration example of an article storage tray according to the first exemplary embodiment;
Fig. 17 is a flowchart of control processing during tray making according to the first exemplary embodiment;
Fig. 18 is a flowchart of a robot controlling process during tray making according to the first exemplary embodiment; and
Fig. 19 is a flowchart of a tray unit controlling process during the tray making according to the first exemplary embodiment.

### DETAILED DESCRIPTION

### (Background to the present disclosure)

In an automated system for achieving an intended article storage condition, there has been a demand for a further improvement in the efficiency of the automated operation. For example, even when a plurality of articles or a plurality of types of articles are to be stored in one storage, it is necessary to achieve an intended condition of storage more accurately in a shorter time period. In the control for storing an intended article in an intended storage section, among a plurality of storage sections provided in a tray that is a storage of the article (hereinafter, this control is also referred to as "tray making"), having been conventionally practiced is causing a robot to pick up the article and to store the article in the intended storage section of the tray. At this time, because many operation steps are included in the sequence of operations for causing the robot to hold an article at the position where the article is supplied, and to move and store the article in the storage position, there has been a demand for an improvement in the efficiency of these operations. The present disclosure is intended to reduce the number of operation steps and to improve the efficiency of the entire system by improving the configuration on a side supplying articles to be stored.

Some exemplary embodiments specifically describing an article supply device according to the present disclosure will now be explained in detail, by making references to the accompanying drawings as appropriate. Unnecessarily detailed description are sometimes omitted. For example, detailed descriptions of a well-known matter or redundant descriptions of substantially the same structures may be omitted. This is to avoid the unnecessary redundancy in the following descriptions and to make the descriptions easier to understand for those skilled in the art. Note that the accompanying drawings and the following descriptions are provided for those skilled in the art to fully understand the present disclosure, and are not intended to limit the subject matter described in the claims.

### <First exemplary embodiment>

### [System configuration]

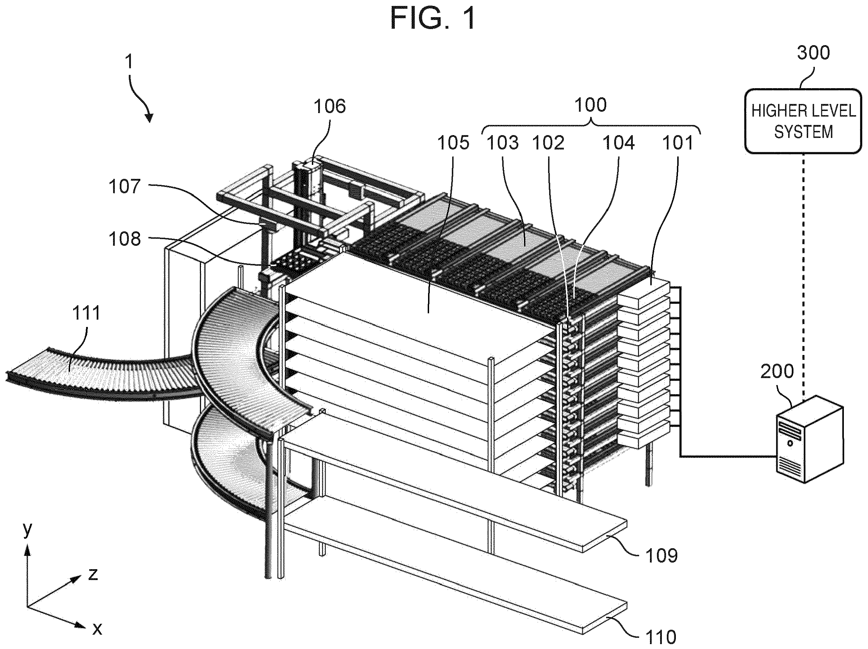

Fig. 1 is a block diagram illustrating a configuration example of a tray making system including an article supply device according to an exemplary embodiment. Tray making system 1 according to the present exemplary embodiment includes tray making unit 100, control system 200, and host system 300. Note that directions in xyz coordinate systems indicated in the respective drawings that are used in the following descriptions correspond to one another. The x axis, the y axis, and the z axis in the xyz coordinate system are orthogonal to one another.

Control system 200 controls the entire operation of tray making system 1, and is implemented as an information processing apparatus such as a personal computer (PC), for example. Control system 200 is connected to tray making unit 100, robot 106, various conveyors, and host system 300 via a wired/wireless network (not illustrated).

Host system 300 provides various types of information required in tray making, to control system 200. Host system 300 may be an information processing device such as a PC, or may be an on-premise server device or cloud server device. The specific information provided herein is not limited to a particular information, but may include information such as configurations of various trays, the number of articles to be stored, and storage positions. Examples of the specific information will be described later.

Tray making unit 100 includes a plurality of tray controllers 101, a plurality of article conveyors 102, a plurality of tray units 103, a plurality of article supply trays 104, and a plurality of tray holders 105. Furthermore, robot 106, camera 107, article storage tray 108, OK tray conveyor 109, article storage tray conveyor 110, and NG tray conveyor 111 are installed around tray making unit 100.

Tray making unit 100 according to the present exemplary embodiment includes one or more of shelves (10 shelves in the example of Fig. 1), and each of the shelves includes one or more of tray units 103 (in the example of Fig. 1, those arranged in 5 columns). Therefore, in the example of Fig. 1, tray making unit 100 includes a total of 50 tray units 103 arranged in 10 rows × 5 columns. Note that the configuration illustrated in Fig. 1 is an example, and the embodiment is not limited thereto. Article supply tray 104 where articles to be supplied are stored is installed in each of one or more tray units 103. The installation of article supply tray 104 will be described later with reference to the drawings.

One or more tray controllers 101 are provided correspondingly to the one or more shelves (10 shelves in the example of Fig. 1) that are included in tray making unit 100. Each of one or more tray controllers 101 is communicatively connected to control system 200, and controls movement of the one or more tray units 103 in the corresponding shelf based on an instruction from control system 200. In the present exemplary embodiment, one tray controller 101 is provided for each shelf, but the embodiment is not limited thereto. For example, one tray controller 101 may be provided for one tray unit 103, or tray controller 101 may be provided correspondingly to a unit other than a shelf.

One or more tray holders 105 are provided correspondingly to one or more shelves (10 shelves in the example of Fig. 1) included in tray making unit 100. After all the articles are supplied from article supply tray 104 installed in tray unit 103, article supply tray 104 is discharged to tray holder 105. The discharging of article supply tray 104 will be described later with reference to the drawings.

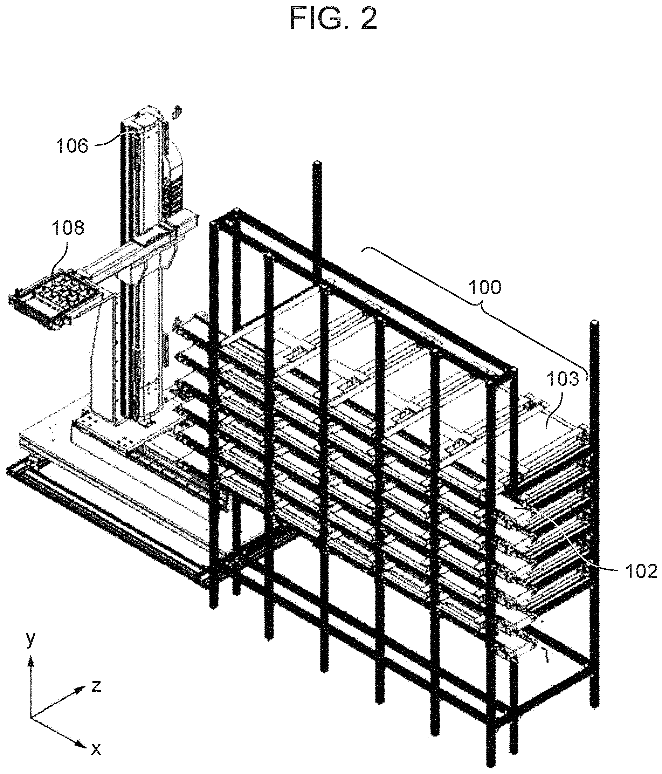

Article conveyor 102 receives each article discharged from article supply tray 104, and conveys the article toward an exit (discharge position). In the present exemplary embodiment, article storage tray 108 held by robot 106 is controlled to be kept at the discharge position, so that an article is received in the intended storage section of article storage tray 108. Article conveyors 102 are provided correspondingly to one or more shelves included in tray making unit 100. The conveyance by article conveyor 102 is controlled by the corresponding tray controller 101. In addition, explained the present exemplary embodiment is an example in which article conveyor 102 is configured as an endless conveyor, but the embodiment is not limited thereto. Furthermore, in the present exemplary embodiment, the discharge positions on respective article conveyors 102 in respective shelves are matched in the x-axis direction and the z-axis direction, as illustrated in Fig. 2. In other words, the exits of the plurality of article conveyors 102 are vertically arranged, and only the heights thereof (coordinates in the y-axis direction) are different. However, the embodiment is not limited to this configuration, and the length, the arrangement, and the like of article conveyors 102 may be changed.

Robot 106 holds article storage tray 108 being delivered by article storage tray conveyor 110, and moves article storage tray 108 to a position for receiving an article being delivered by article conveyor 102, so that the article is stored at a specified position of article storage tray 108. This operation will be described later with reference to the drawings. The operation of robot 106 is controlled by control system 200.

Camera 107 captures an image of article storage tray 108 having articles stored by the operation of robot 106. In the present exemplary embodiment, after a series of operations for storing articles in one article storage tray 108 is completed, robot 106 moves article storage tray 108 to the area an image of which is captured by camera 107, so that the image thereof is captured. The captured image is transmitted to control system 200. Control system 200 determines whether the condition of the storage of the articles in article storage tray 108 is correct, that is, whether the intended articles are correctly stored in the respective target positions (storage sections) of article storage tray 108, based on the image acquired via camera 107. The determination as to whether the storage condition is correct may be made based on information provided by host system 300, for example. Note that camera 107 may include a plurality of cameras. The image does not need to be captured at a fixed position upon completion of the series of storing operations. For example, the image may be captured during the series of storing operations, and the determination as to whether the condition of the storage is correct may be made in real time.

OK tray conveyor 109 is a conveyor for conveying an article storage tray having its storage condition determined to be correct, based on an image captured by camera 107 (hereinafter, also referred to as an OK tray). OK tray conveyor 109 conveys an OK tray to a predetermined position. A destination to which the tray is conveyed is not limited to a particular destination, but for example, the tray may be conveyed to a subsequent device (not illustrated) that performs packing or the like. After the series of storing operations has been completed, robot 106 moves the OK tray to the OK tray conveyor 109.

Article storage tray conveyor 110 conveys an empty article storage tray 108 before any articles are stored, toward a position where robot 106 can hold the tray. Robot 106 holds the empty article storage tray 108 conveyed by article storage tray conveyor 110 at the predetermined position, and performs operations for storing an article in article storage tray 108.

NG tray conveyor 111 conveys an article storage tray having its storage condition determined to be incorrect based on an image captured by camera 107 (hereinafter, also referred to as an NG tray). NG tray conveyor 111 conveys the NG tray to a predetermined position. A destination to which the tray is conveyed is not limited to a particular destination, but for example, the tray may be conveyed to a subsequent device (not illustrated) for performing an operation for reusing the articles in the NG tray. After the series of storing operations has been completed, robot 106 moves the NG tray to NG tray conveyor 111.

Note that the configurations of the OK tray conveyor 109, article storage tray conveyor 110, and NG tray conveyor 111 are not limited to those illustrated in Fig. 1, and may have a different configuration correspondingly to each conveyor. For example, a part where empty article storage trays 108 are stacked may be provided instead of article storage tray conveyor 110, and robot 106 may be configured to hold article storage tray 108 from the part. In addition, the configuration is not limited to the configuration in which OK tray conveyor 109 and NG tray conveyor 111 are separately provided, and in which robot 106 places article storage tray 108 after the storing operation on one of the conveyors. For example, robot 106 may be configured to set article storage trays 108 after the storing operation on the same conveyor, and determine whether a tray is OK tray or an NG tray while the tray is being conveyed by the conveyor. In this case, a camera for capturing an image of article storage tray 108 being conveyed is installed along the path of the conveyor.

In addition, explained in the present exemplary embodiment is an example in which two conveyors of OK tray conveyor 109 and NG tray conveyor 111 are used as the destinations to which article storage trays 108 are discharged. However, the embodiment is not limited to this configuration, and it is also possible to provide more conveyors. For example, a more detailed determination may be made for NG trays, and the destination to which an NG tray is discharged may be selected from a plurality of conveyors based on the article missing in article storage tray 108. In addition, a more detailed determination may be made for NG trays, and if there are no missing articles but their positions stored in article storage tray 108 are different, the destination to which the NG tray is discharged may be selected from a plurality of conveyors based on the arrangement of the articles. In this case, the tray may also be handled as an OK tray and select the destination to which the tray is conveyed. With this configuration, the trays may be classified into a larger number of groups, instead of two groups of OK trays and NG trays, based on the storage conditions achieved by the storing operations. In addition, when the destination where the trays are discharged is already full with the processed article storage trays 108, another destination for discharging the tray may be selected.

Fig. 2 is an external perspective view illustrating a part corresponding to tray making unit 100 and robot 106 included in tray making system 1 illustrated in Fig. 1. As illustrated in Fig. 2, article conveyor 102 is positioned in such a manner that articles can be received from the tray units 103 on the shelf corresponding thereto, and can convey the article toward robot 106. Robot 106 can hold and move article storage tray 108 to a position where an article is received from article conveyors 102. In the example illustrated in Fig. 2, robot 106 is configured to be able to move article storage tray 108 to a coordinate position in a three-dimensional space represented by an xyz coordinate system.

Note that illustrated in Figs. 1 and 2 is an example of a configuration in which one robot 106 is provided, but the embodiment is not limited thereto. For example, a plurality of robots 106 may be configured to operate simultaneously in parallel. In addition, illustrated in Figs. 1 and 2 is a configuration in which one robot 106 is capable of holding one article storage tray 108, but the embodiment is not limited thereto. For example, one robot 106 may be configured to be capable of holding a plurality of article storage trays 108, and the operation of storing articles in article storage trays 108 may be performed simultaneously in parallel.

### [Control system]

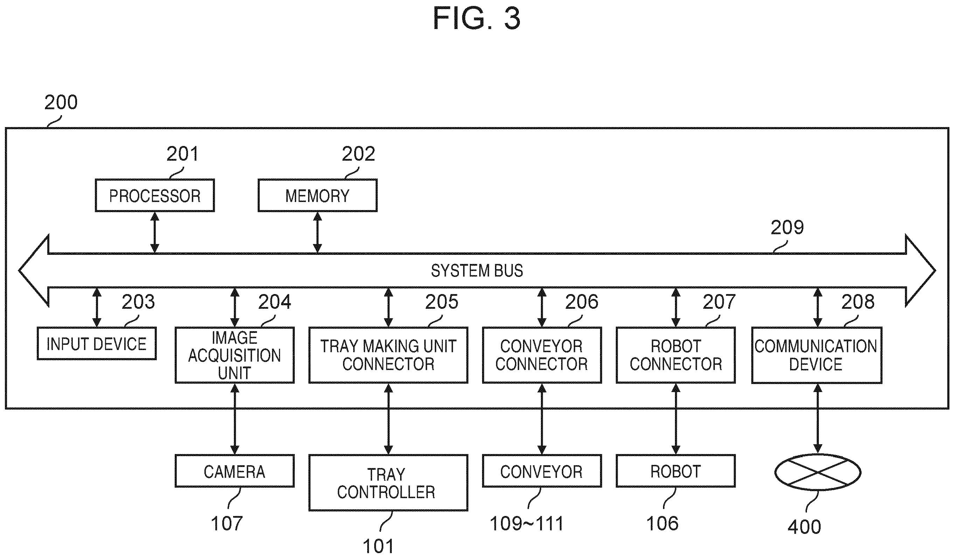

Fig. 3 is a block diagram illustrating a configuration example of control system 200 according to the present exemplary embodiment. Control system 200 includes processor 201, memory 202, input device 203, image acquisition unit 204, tray making unit connector 205, conveyor connector 206, robot connector 207, and communication device 208.

Processor 201 is an example of a processor that reads various programs and data stored in the memory 202 and executes processing to implement various functions according to the present exemplary embodiment. Processor 201 may be configured using at least one of a central processing unit (CPU), a micro processing unit (MPU), a digital signal processor (DSP), a graphical processing unit (GPU), or a field programmable gate array (FPGA). Memory 202 is a storage area for storing therein and retaining data corresponding to various types of information, and includes, for example, a read-only memory (ROM) that is a nonvolatile storage area, a random access memory (RAM) that is a volatile storage area, and a hard disk drive (HDD).

Input device 203 receives data corresponding to a user's instruction from a mouse or a keyboard (not illustrated), for example. Image acquisition unit 204 is communicatively connected to camera 107, and acquires an image captured by camera 107. Furthermore, image acquisition unit 204 may be configured to transmit an instruction of processor 201 for causing camera 107 to capture an image. Tray making unit connector 205 is communicably connected to one or more tray controllers 101. Tray making unit connector 205 transmits various instructions of processor 201 to tray controller 101. Conveyor connector 206 is connected to a drive unit (e.g., a motor) that controls the operation of the conveyors. Conveyor connector 206 transmits various instructions of processor 201 to the conveyors. In the present exemplary embodiment, article conveyors 102 are described as being controlled by tray controllers 101, but may be configured to be controlled by control system 200 directly, via conveyor connector 206.

Robot connector 207 is connected to a drive unit (e.g., a motor) that controls the operation of robot 106. Robot connector 207 transmits various instructions of processor 201 to robot 106. Communication device 208 communicates with an external device (for example, host system 300) via wired/wireless network 400, and transmits and receives various data and signals. A communication protocol used by communication device 208 is not limited to a particular protocol, and communication device 208 may support a plurality of communication protocols. For example, a wide area network (WAN), a local area network (LAN), power line communication, or near-field communication (e.g. Bluetooth (registered trademark)) may be used.

### [Article supply tray]

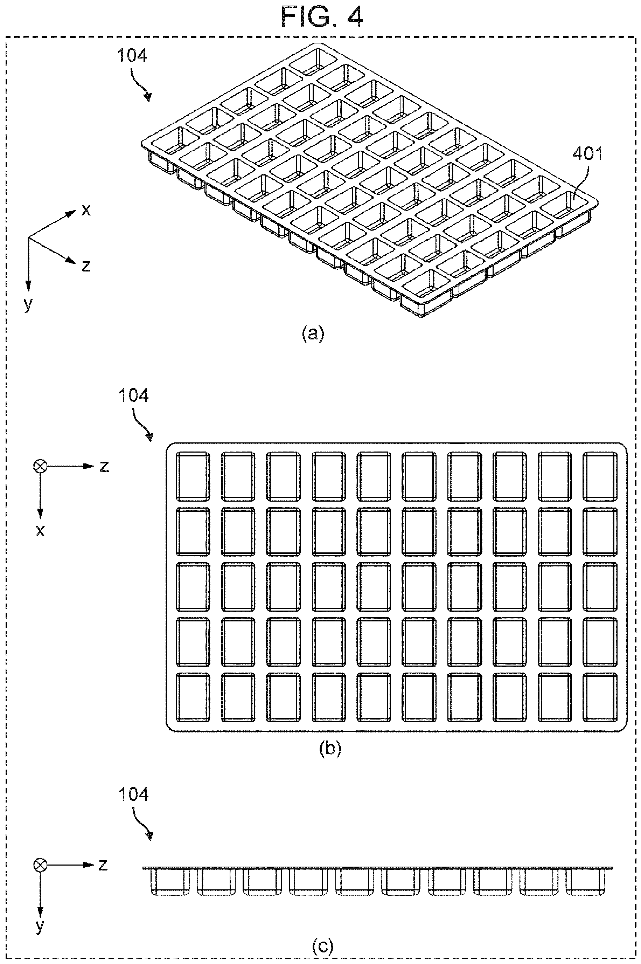

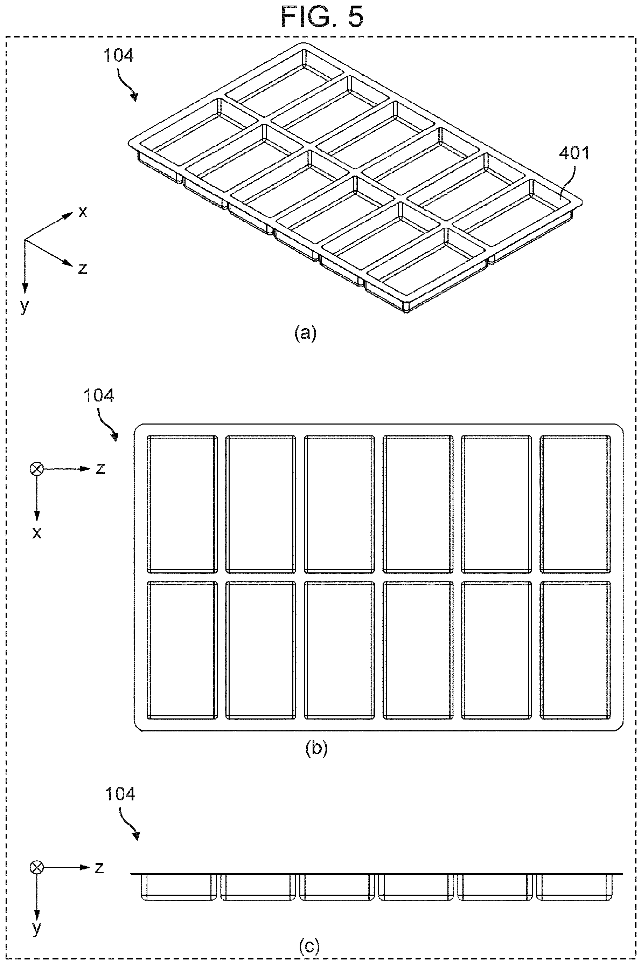

Figs. 4 and 5 are external views illustrating a configuration example of article supply tray 104 according to the present exemplary embodiment. Part (a) to part (c) of Fig. 4 are schematics of article supply tray 104 viewed from different directions. Similarly, part (a) to part (c) of Fig. 5 are schematics of article supply tray 104 viewed from different directions.

Fig. 4 illustrates a configuration example of article supply tray 104 including five storage sections 401 in the x-axis direction and ten in the z-axis direction, fifty storage sections in total. Any article can be stored in each of the storage sections 401. At this time, the x-axis direction corresponds to a direction extending along a conveying direction of article conveyor 102. Fig. 5 illustrates a configuration example of article supply tray 104 including two storage sections 401 in the x-axis direction and six in the z-axis direction, twelve storage sections in total. Note that the configuration of article supply tray 104 is an example, and is not limited to the configuration illustrated in Figs. 4 and 5. For example, it is possible to use a plurality of types of article supply trays 104 having the same number of storage sections 401 but different dimensions (width, height, depth), or those having storage sections 401 of different shapes.

As illustrated in Fig. 1, the tray making system 1 is provided with a plurality of tray units 103. Article supply trays 104 having the same configuration may be used in the plurality of tray units 103, or article supply trays 104 having a different configuration may be used in each tray unit 103. Article supply tray 104 to be used may be determined based on the article to be supplied, and control system 200 manages information related to which tray unit 103 uses article supply trays 104 having which configuration. In addition, the material or the like of article supply tray 104 is not limited to a particular material or the like, and may be changed based on the material or the like of the articles stored in the storage sections 401, for example.

### [Tray unit]

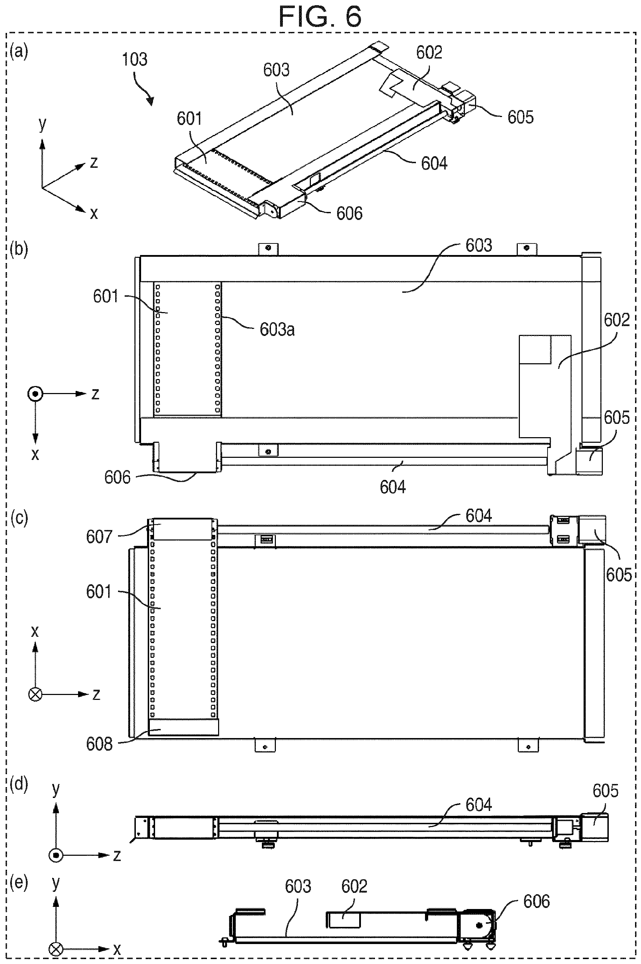

Fig. 6 is an external view illustrating a configuration example of tray unit 103 according to the present exemplary embodiment. Part (a) to part (e) of Fig. 6 are views of tray unit 103 viewed from different directions. Illustrated in these drawings is tray unit 103 with no article supply tray 104 installed.

Tray unit 103 includes shutter 601, pushing portion 602, article supply tray holding unit 603, rotation shaft 604, motor 605, and drum 606. Rotation shaft 604 and motor 605 are an example of drive unit that drives shutter 601. Shutter 601 includes a planar shutter sheet, for example, and is opened and closed as the rotation shaft 604 is rotated. Part (c) of Fig. 6 is a schematic of tray unit 103 as viewed from below, and illustrates shutter 601 as closed (fully closed). With shutter 601 being fully closed, it is sufficient for the opening to be closed by shutter 601 so that the article is not discharged (does not fall) from article supply tray 104 installed in tray unit 103, and the opening does not need to be completely closed, in terms of the structure. Similarly to being fully closed, with shutter 601 being fully opened, it is only necessary for the entire articles to be discharged (fall) from article supply tray 104 installed in tray unit 103, and the opening does not need to be completely opened, in terms of the structure.

Opening 603a is provided to article supply tray holding unit 603, at the position where shutter 601 is provided. Part (b) of Fig. 6 is a schematic of tray unit 103 as viewed from above, and closed shutter 601 is visible through opening 603a provided to article supply tray holding unit 603. When shutter 601 is opened, the article stored in article supply tray 104 drops onto article conveyor 102 (an example of the article reception portion) through opening 603a. The position of pushing portion 602 also changes as the rotation shaft 604 is rotated. Pushing portion 602 functions as a movement portion for moving article supply tray 104 installed in tray unit 103. A specific operation of pushing portion 602 will be described later. In the following description, an operation of causing shutter 601 to open so as to expose opening 603a provided in article supply tray holding unit 603 will be also referred to as an opening operation. Similarly, the operation of causing shutter 601 to close so as to close opening 603a provided in article supply tray holding unit 603 will be also referred to as a closing operation.

Motor 605 is implemented as a stepping motor, for example, is rotatable in a clockwise (CW) direction and a counterclockwise (CCW) direction, and rotates the rotation shaft 604 connected thereto. For convenience, a clockwise (CW) rotation direction will be also referred to as a first rotation direction, and a counterclockwise (CCW) rotation direction will be also referred to as a second rotation direction. Note that these corresponding relationship between the rotation directions is an example, and may be reversed. Rotation shaft 604 is provided as a ball screw, for example, and is connected to pushing portion 602 and drum 606. As illustrated in part (c) of Fig. 6, protrusion 608 is provided at an end of shutter 601. Protrusion 607 is also provided below drum 606. Although details will be described later, drum 606 is provided with a torque sensor. When protrusion 608 comes into contact with protrusion 607 as motor 605 is rotated in the direction in which shutter 601 is opened (in the example herein, rotated in the CW direction), and causes a change in the detection of the torque, the torque sensor detects that shutter 601 has been fully opened. Similarly, when the protrusion 608 comes into contact with the end of tray unit 103 as motor 605 is rotated in the direction in which shutter 601 is closed (in the example herein, rotated in the CCW direction) and causes a change in the detection of the torque, the torque sensor detects that shutter 601 has been fully closed.

Note that shutter 601 according to the present exemplary embodiment is illustrated to have a shape of one sheet, but is not limited to this shape. For example, shutter 601 may have a block shape having a constant thickness, or may include a plurality of slidable thin plates.

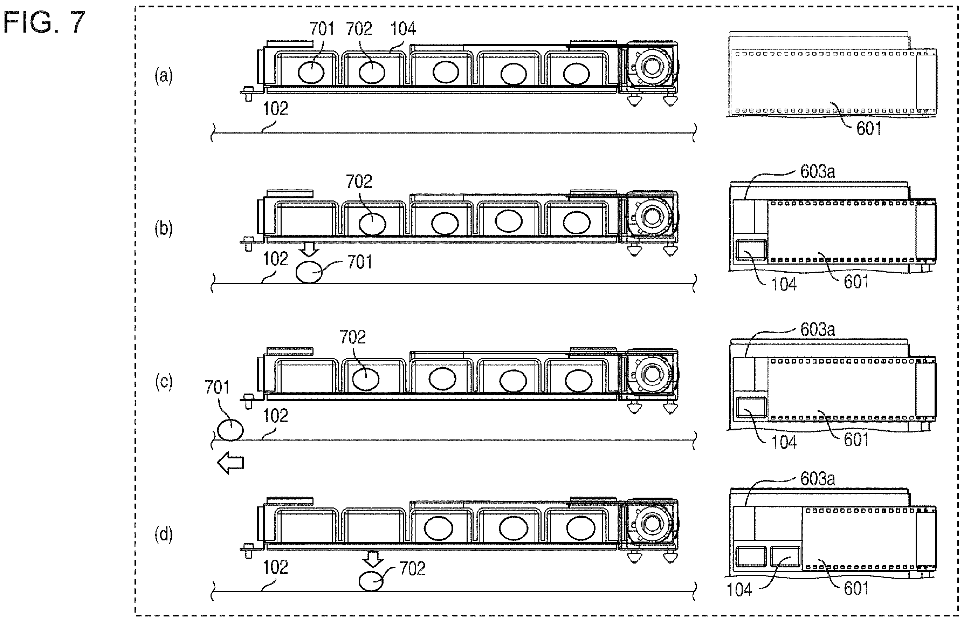

Fig. 7 is a schematic diagram illustrating an operation of discharging articles from article supply tray 104 installed in tray unit 103 onto article conveyor 102. This operation proceeds from part (a) to part (d) of Fig. 7. Illustrated on the left side in Fig. 7 are schematics of tray unit 103 in a view along the z axis, and illustrated on the right side are schematics of tray unit 103 viewed from the bottom (from the side of article conveyor 102) along the y axis. In each of part (a) to part (d) of Fig. 7, the schematics on the left side and right side correspond to each other. In the example explained herein, article supply tray 104 have five storage sections in the x-axis direction. An article is stored in each of the storage sections of article supply tray 104, and article supply tray 104 is installed in tray unit 103 in such a manner that the open sides of the storage sections face downwards.

Part (a) of Fig. 7 illustrates a condition in which shutter 601 is fully closed. In this condition, the open side of article supply tray 104 is closed by shutter 601, and the articles in article supply tray 104 are not discharged (does not fall) onto article conveyor 102. Part (b) of Fig. 7 illustrates a condition in which shutter 601 is opened by a length corresponding to one storage section in the x-axis direction. As a result, article 701 inside the storage section on the leftmost side of article supply tray 104 drops and is discharged onto article conveyor 102. As illustrated in part (c) of Fig. 7, article conveyor 102 carries the fallen article 701 toward article storage tray 108 being held by robot 106. Part (d) of Fig. 7 illustrates a condition in which shutter 601 is further opened by a length corresponding to one storage section in the x-axis direction, from the condition illustrated in part (b) of Fig. 7. As a result, article 702 falls out of a second storage section from the left in article supply tray 104, and is discharged onto article conveyor 102. This operation is repeated until shutter 601 becomes fully opened, that is, until the operation completes for the entire row of storage sections of article supply tray 104.

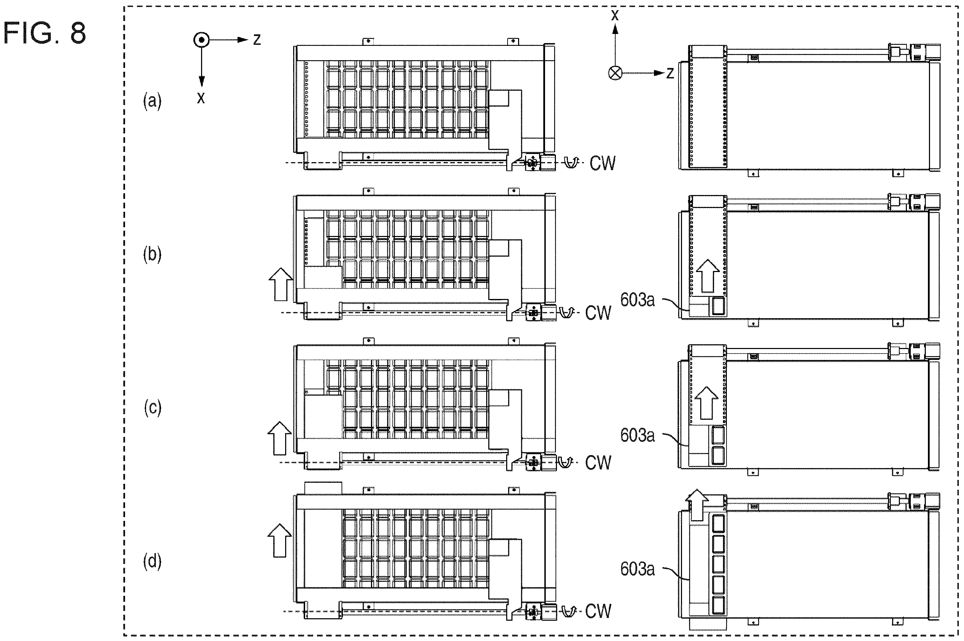

Fig. 8 is an external view for explaining the movement of shutter 601 in tray unit 103 with article supply tray 104 installed. The operations are performed from part (a) to part (d) of Fig. 8. Illustrated on the left side in Fig. 8 are schematics of tray unit 103 in a view from the top along the y axis, and illustrated on the right side are schematics of tray unit 103 viewed from the bottom (from the side of article conveyor 102) along the y axis. In each of part (a) to part (d) of Fig. 8, the left and right diagrams correspond to each other. In the example explained herein, article supply tray 104 have five storage sections in the x-axis direction. In addition, this explanation assumes that shutter 601 is opened by causing motor 605 to rotate in the CW direction.

Part (a) of Fig. 8 illustrates a condition in which shutter 601 is fully closed. Part (b) of Fig. 8 illustrates a condition in which shutter 601 is opened by a length corresponding to one storage section in the x-axis direction. At this time, a part of the planar shutter 601 is visible on the top of tray unit 103, by a length having been opened. Part (c) of Fig. 8 illustrates a condition in which shutter 601 is opened further by a length corresponding to one storage section in the x-axis direction. In a view from the bottom, two storage sections of article supply tray 104 are visible through opening 603a. Part (d) of Fig. 8 illustrates a condition in which shutter 601 is fully opened. In a view from the bottom, five storage sections corresponding to the entire one row are visible through opening 603a. At this time, most of shutter 601 is visible on the top of tray unit 103.

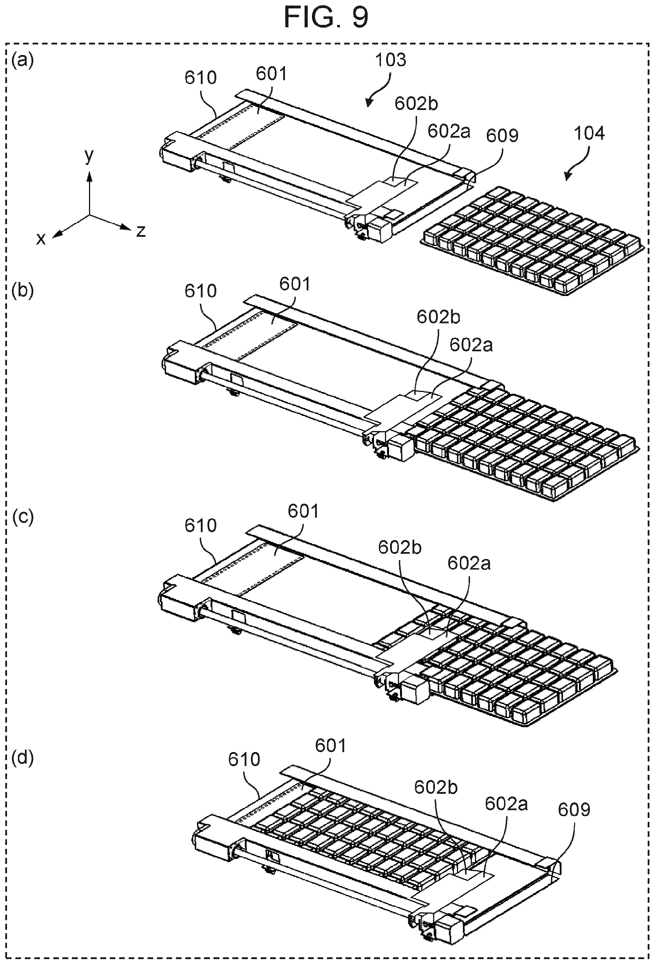

Fig. 9 is an external perspective view for explaining a sequence in which new article supply tray 104 is inserted (installed) into tray unit 103. It is assumed that article supply tray 104 is inserted in the order of part (a) to part (d) of Fig. 9. In the present exemplary embodiment, article supply tray 104 is inserted from insertion portion 609 that is located on the opposite side of shutter 601 in tray unit 103. In other words, article supply tray 104 is inserted from the rear side in the z-axis direction as illustrated in Fig. 1. In addition, tray unit 103 also has discharge portion 610 through which article supply tray 104 is discharged, on the opposite side of the insertion portion 609, that is, on the side of shutter 601. Article supply tray 104 is discharged to tray holder 105 by being pushed out by the pushing portion 602, and discharged from the discharge portion 610. At this time, article supply tray 104 is inserted into tray unit 103 upside down, that is, in such a manner that the open side faces downwards. Because article supply tray 104 is kept upside down, a support member (not illustrated) such as a lid is provided on the open side of article supply tray 104, so that the article does not fall from article supply tray 104 during the process of insertion. This support member is removed as the tray is inserted.

Pushing portion 602 includes support 602a and inclined portion 602b. Support 602a is provided in a manner facing the bottom surface of article supply tray holding unit 603, and is configured to become displaced as rotation shaft 604 is rotated. Furthermore, inclined portion 602b has a constant inclination with respect to support 602a. The inclination angle of the inclined portion 602b herein is not limited to a particular angle, but is set to an angle suitable for both of an operation of pushing out article supply tray 104 held on article supply tray holding unit 603, and an operation of inserting article supply tray 104 onto article supply tray holding unit 603. In addition, in the condition illustrated in part (c) of Fig. 9, pushing portion 602 may be configured to be pushed up by article supply tray 104 upwards in the y axis so that the insertion of article supply tray 104 is not obstructed thereby. In other words, pushing portion 602 may be configured to allow some changes in shape, e.g., to move in the vertical direction, to have the inclination angle of inclined portion 104b change, and to have support 602a deformed, by inclined portion 602b being brought into contact with article supply tray 104 as the article supply tray 104 is being inserted. In the condition illustrated in part (d) of Fig. 9, the insertion of article supply tray 104 has been completed, and pushing portion 602 is ready to push article supply tray 104 toward shutter 601.

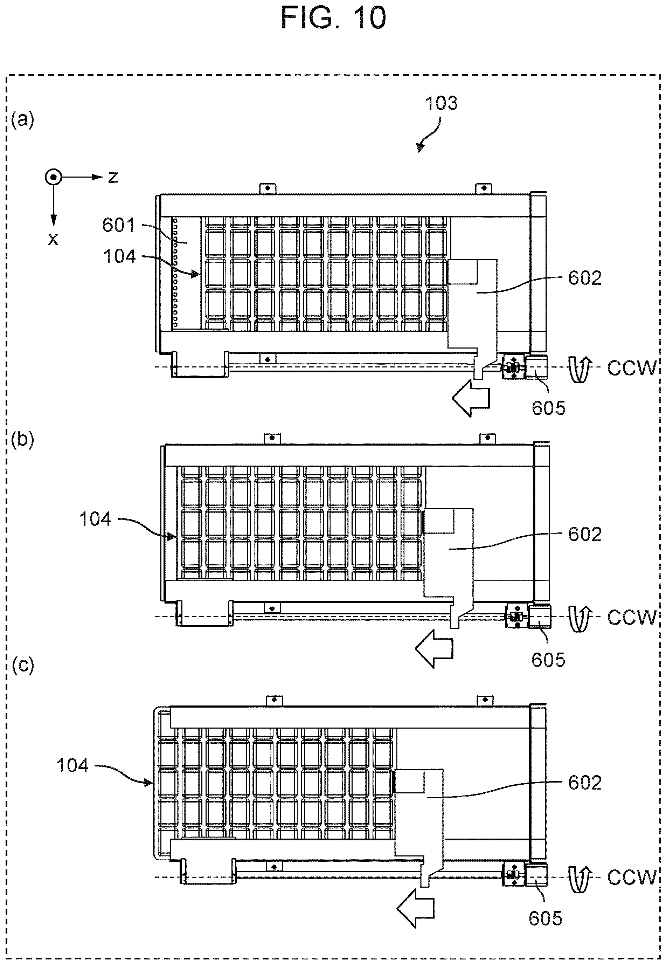

Fig. 10 is a schematic diagram for explaining an operation in which tray unit 103 pushes out article supply tray 104. Part (a) of Fig. 10 illustrates a condition in which shutter 601 is fully closed by the rotation of motor 605 in the CCW direction. Furthermore, as motor 605 continues to rotate in the CCW direction, pushing portion 602 moves toward shutter 601 along the z axis, and pushes out article supply tray 104. The amount by which article supply tray 104 is pushed out is controlled by the amount by which of motor 605 is rotated (that is, the amount of rotation in the CCW direction), and is adjusted correspondingly to the length of one row of the storage section in the z-axis direction of article supply tray 104 having been installed. In other words, the operation of pushing out article supply tray 104 is controlled in units of one row of the storage sections of article supply tray 104.

After the articles across the entire rows of the article supply trays 104, that is, across the entire storage sections have been completely supplied, article supply tray 104 is pushed out so as to be discharged from tray unit 103. In the present exemplary embodiment, empty article supply tray 104 is discharged to tray holder 105.

Note that the series of insertion operations illustrated in Fig. 9 may be performed manually or may be performed by a device (not illustrated) provided for the insertion. Furthermore, empty article supply tray 104 discharged from tray unit 103 after the series of pushing operations in Fig. 10 may be accumulated in tray holder 105 and manually collected, or this process may be performed by a device (not illustrated) provided for collection.

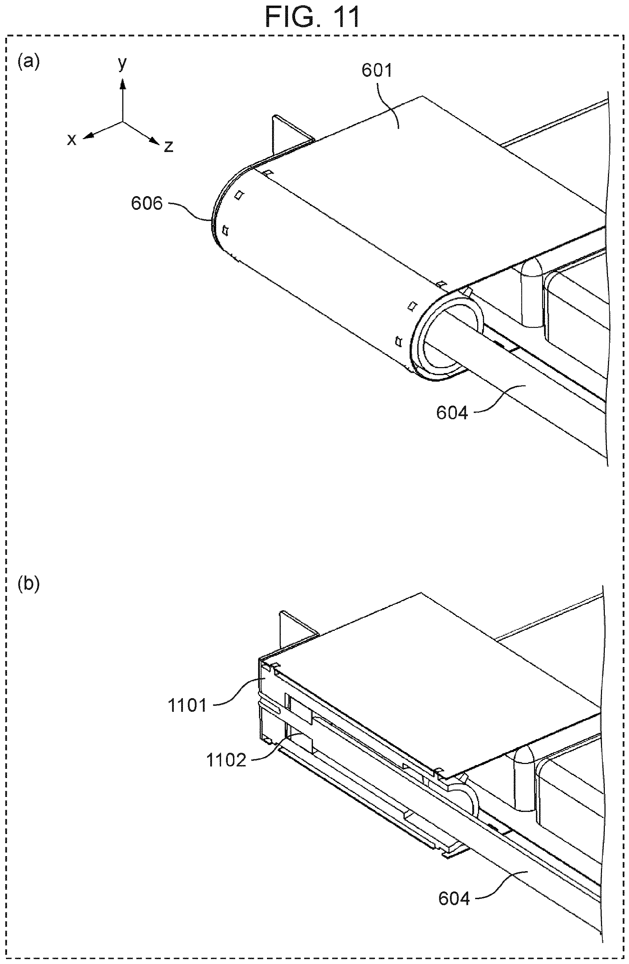

Fig. 11 is a schematic diagram for explaining structures around drum 606 in tray unit 103. As illustrated in part (a) of Fig. 11, planar shutter 601 is kept in contact with a surface of drum 606, and shutter 601 is opened and closed as drum 606 is rotated by the rotation of the rotation shaft 604. Shutter 601 has a plurality of holes (recesses), and become engaged with protrusions (projections), respectively, that are provided on drum 606, so that the movement of shutter 601 is synchronized with the movement of drum 606.

Part (b) of Fig. 11 illustrates a cross section of drum 606 on the yz plane. Drum 606 includes rotation drum 1101 and torque limiter 1102. As rotation shaft 604 is rotated, rotation drum 1101 is also rotated. Torque limiter 1102 is configured to spin in idle upon being applied with a torque equal to or greater than a predetermined level. As illustrated in part (c) of Fig. 6, for example, protrusion 608 is provided to shutter 601, and when rotation drum 1101 keeps rotating while the protrusion is in contact with the end of tray unit 103, a change occurs in the torque. As a result, a detection as to shutter 601 is fully opened or fully closed can be made. When rotation shaft 604 is kept rotated in this condition, drum 606 is caused to spin in idle due to the presence of torque limiter 1102.

When shutter 601 is fully closed (as illustrated in part (a) of Fig. 10), the operation illustrated in Fig. 10 is performed by causing rotation shaft 604 to keep rotating in the CCW direction.

Explained in the present exemplary embodiment is the configuration in which the operation of shutter 601 and the operation of pushing portion 602 are integrated. However, these operations may be implemented using a configuration other than the torque limiter. For example, software may control the operation of shutter 601 and the operation of pushing portion 602, separately.

### [Robot]

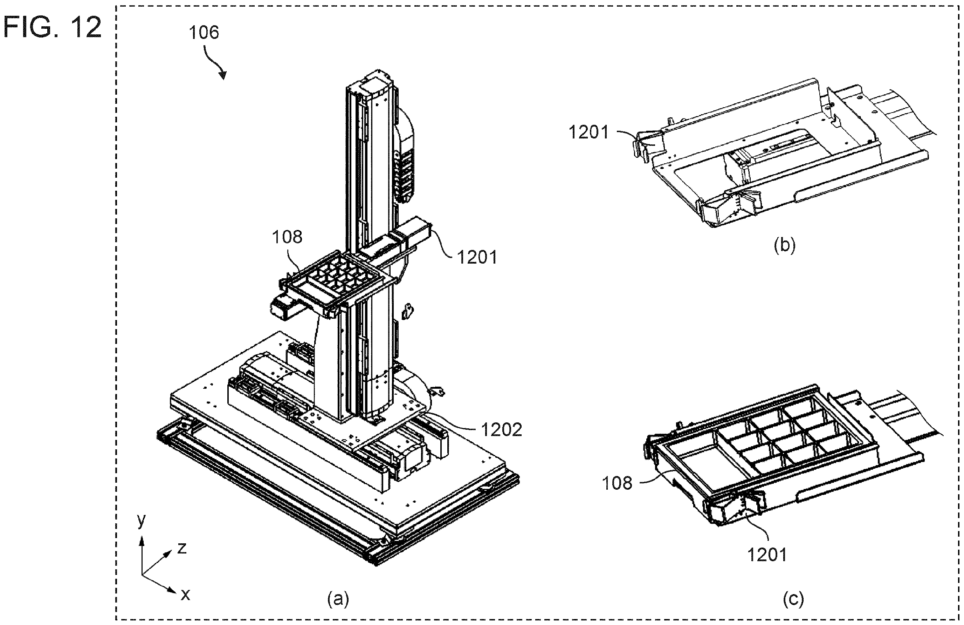

Fig. 12 is an external perspective view illustrating a configuration example of robot 106 according to the present exemplary embodiment. Part (a) of Fig. 12 is an external perspective view illustrating the entire configuration of robot 106. Robot 106 includes article storage tray holding unit 1201 and drive unit 1202. Article storage tray holding unit 1201 holds empty article storage tray 108 being delivered by article storage tray conveyor 110. Robot 106 causes article storage tray holding unit 1201 and drive unit 1202 to adjust the position of article storage tray 108 within the xyz-axis coordinate system in such a manner that each article delivered by article conveyor 102 is stored in an intended position (storage section) of article storage tray 108. The movable ranges of article storage tray holding unit 1201 and drive unit 1202 are not limited to particular ranges. For example, the movable range of article storage tray holding unit 1201 may be set so as to enable positional adjustments in the y-axis direction and the z-axis direction, and the movable range of drive unit 1202 may be set so as to enable positional adjustments in the x-axis direction.

Part (b) of Fig. 12 illustrates article storage tray holding unit 1201 not holding article storage tray 108. Part (c) of Fig. 12 illustrates article storage tray holding unit 1201 holding article storage tray 108. Article storage tray holding unit 1201 may include a part or the like for fixing article storage tray 108 so that article storage tray 108 held thereby does not fall, or not become displaced during the storing operation. In addition, article storage tray holding unit 1201 is provided with a part for performing an operation of receiving and holding empty article storage tray 108 from article storage tray conveyor 110, and an operation of discharging article storage trays 108 for which the storing operations have been completed, to OK tray conveyor 109 and NG tray conveyor 111. The configurations mentioned herein are not limited to particular configurations, but may be configured according to the shape of each conveyor, the shape of article storage tray 108, and the like.

### [Article storing operation]

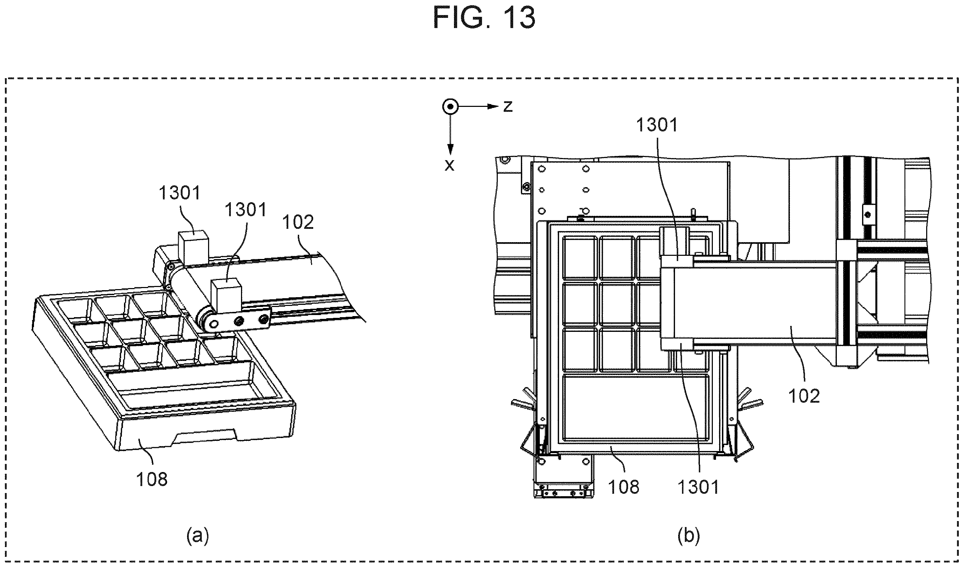

Fig. 13 is a schematic diagram for explaining a positional relationship when an article is stored in article storage tray 108. As illustrated in part (a) and part (b) of Fig. 13, to receive an intended article delivered by article conveyor 102, the position of article storage tray 108 is adjusted so that the intended storage section of article storage tray 108 is brought to a position matching the end of article conveyor 102, that is, the position where the article falls. In the present exemplary embodiment, sensor 1301 is installed at the end of article conveyor 102. Sensor 1301 is a sensor for detecting passage of an article, and may be implemented as a line sensor or a camera, for example. Detecting the passage of an article is equivalent to the fact that an article has been discharged (dropped) from article conveyor 102 toward article storage tray 108, and the article has been stored (supplied) in a storage section of article storage tray 108. In the present exemplary embodiment, sensor 1301 and camera 107 are used together to determine whether an article has been stored. However, the embodiment is not limited to this configuration, and it is also possible to use only camera 107 to determine that an article has been stored.

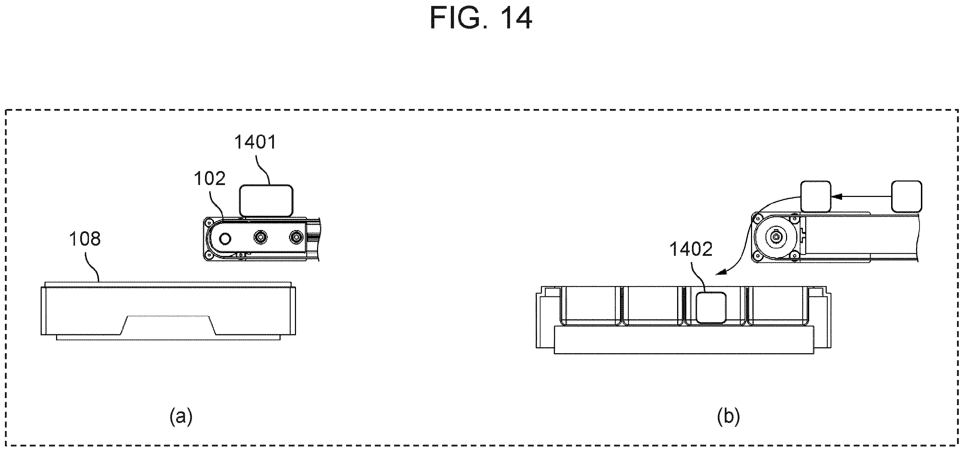

Fig. 14 is a diagram for explaining a process in which an article is stored in article storage tray 108. Article conveyor 102 conveys the article discharged from article supply tray 104 as appropriate, and the article is discharged (dropped) from the end thereof onto article storage tray 108. Part (a) of Fig. 14 illustrates article 1401 being conveyed by article conveyor 102. Part (b) of Fig. 14 illustrates article 1402 having been fallen from the end of article conveyor 102, and being stored in article storage tray 108, after the article 1402 is conveyed by article conveyor 102.

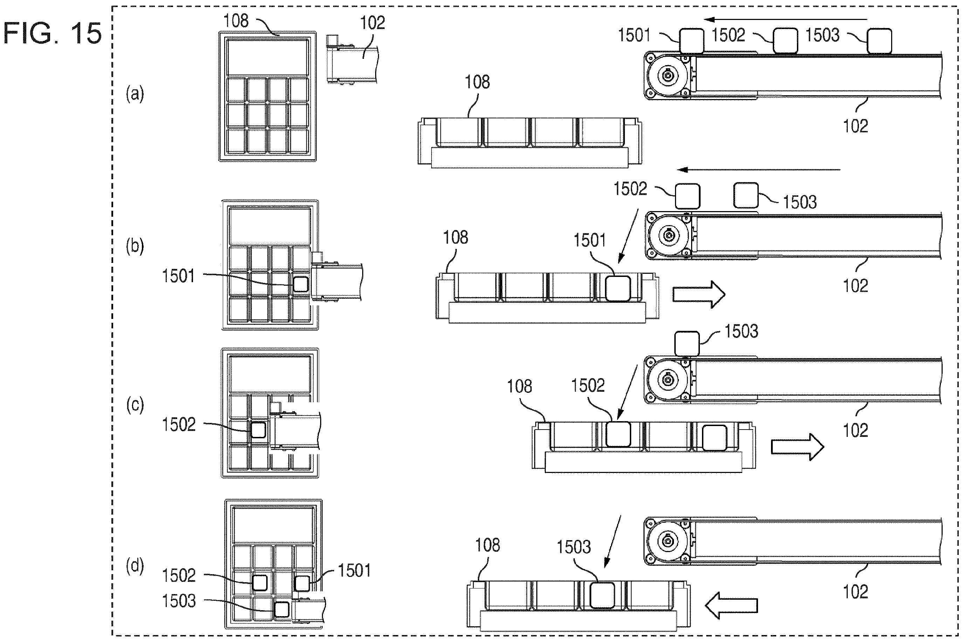

Fig. 15 is a diagram for explaining a sequence of storing an article in an intended storage section of article storage tray 108. It is assumed that the operations are performed in the order from part (a) to part (d) of Fig. 15. As described above, the position of article storage tray 108 is appropriately adjusted by robot 106. In addition, Fig. 15 illustrates an example in which a plurality of articles 1501, 1502, and 1503 being delivered by one article conveyor 102 are to be stored in article storage tray 108.

To begin with, as illustrated in part (a) of Fig. 15, robot 106 moves article storage tray 108 held thereby near the position where an article is discharged from article conveyor 102 delivering the intended article. The position used herein may be defined in advance, or may be acquired based on the shape of article storage tray 108 or the position of the storage section where the article is stored. In addition, as illustrated in Fig. 1, when tray making unit 100 of the tray making system 1 includes a plurality of shelves, and it is necessary to supply articles across the plurality of shelves into one article storage tray 108, it is possible to adjust the order in which or the speed at which article storage tray 108 is moved near the discharge positions of article conveyors 102 corresponding to the respective shelves, for example, as appropriate, from the viewpoint of improving the efficiency of the storing operation.

As illustrated in part (b) to part (d) of Fig. 15, robot 106 then controls the position of article storage tray 108 based on the timing at which each of the plurality of articles 1501, 1502, and 1503 being delivered is to be discharged, and the position of the storage section where the article is to be stored. Note that explained in the example illustrated in Fig. 15 is the control of moving article storage tray 108 in the horizontal direction, that is, along the xz-axis plane of Fig. 1, but it is also possible to control to move article storage tray 108 in the vertical direction, too, that is, in the y-axis direction. For example, article storage tray 108 may be controlled to move in the y-axis direction depending on the material of the article being conveyed. Furthermore, the position in the y-axis direction may be adjusted in such a manner that a difference between the height of the conveyance surface of article conveyor 102 and the height of the receiving surface of article storage tray 108 (that is, the bottom surface of the storage section of article storage tray 108) in the y-axis direction falls within a certain range.

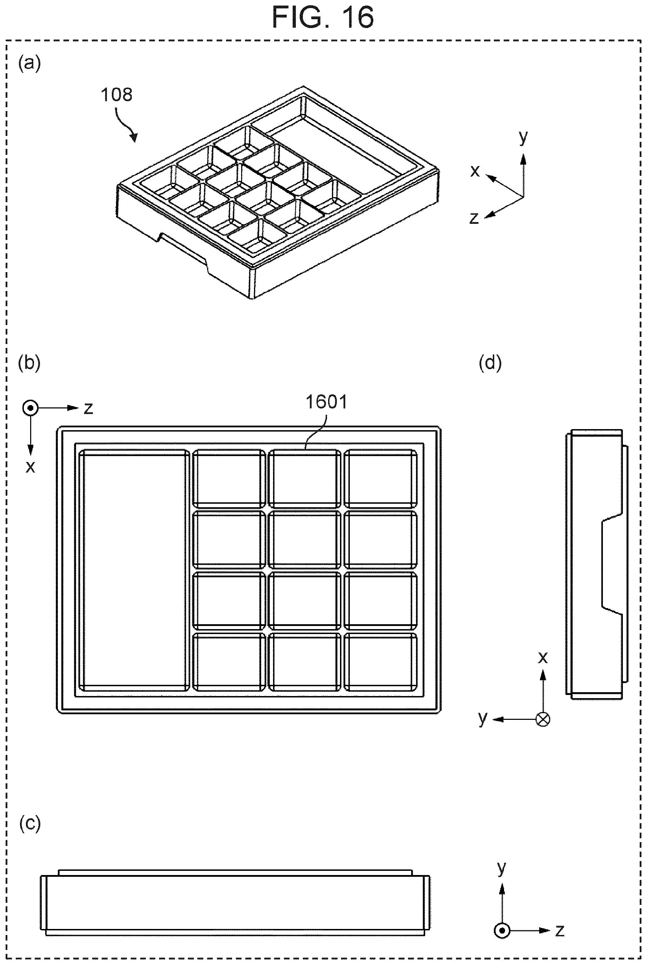

Fig. 16 is an external view illustrating a configuration example of article storage tray 108 according to the present exemplary embodiment. Article storage tray 108 has a plurality of storage sections 1601 for storing therein articles. All of the storage sections included in a single article storage tray 108 may have the same shape, or may include a plurality of shapes, as in the example illustrated in Fig. 16 (in this example, there are two different shapes). In addition, the material of article storage tray 108 may be the same as or different from the material of article supply tray 104.

### [Operation sequence]

### (Overall operation)

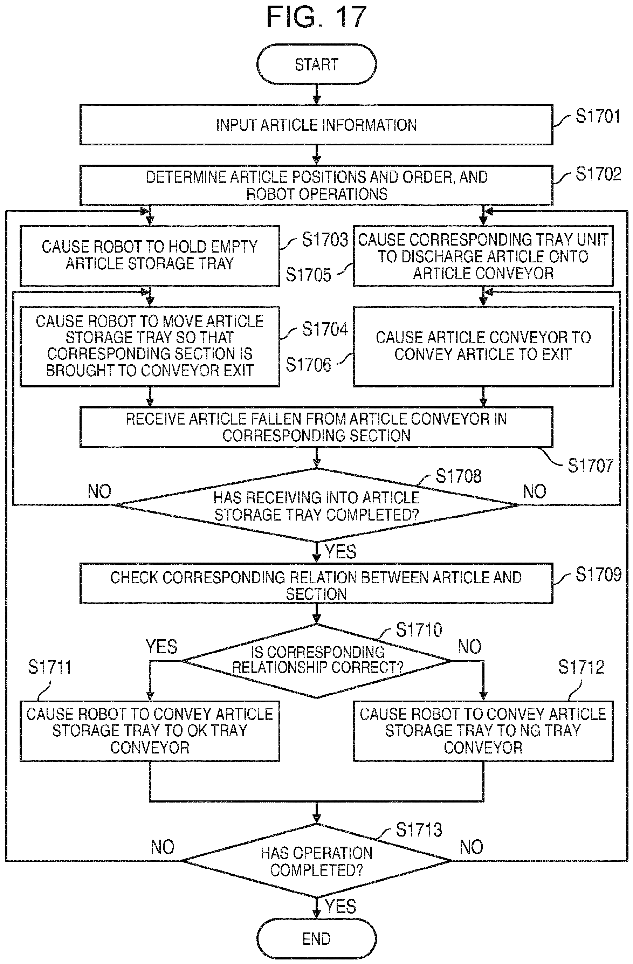

Fig. 17 is a sequence chart of the entire operation of tray making system 1 according to the present exemplary embodiment. The operation of the tray making system 1 is generally divided into an operation of tray unit 103 and an operation of robot 106. In Fig. 17, these operations will be explained together. It is assumed that, when the operation of the tray making system 1 is started, the motor or the like corresponding to each conveyor is started to rotate, and keeps the corresponding conveyor in operation. In addition, in order to simplify the explanation herein, it is assumed that control system 200 controls the entire parts comprehensively.

Control system 200 receives an input of article information (step S 1701). The article information includes, for example, a shape of article supply tray 104, a shape of article storage tray 108, arrangement of articles (article supply tray 104) within the tray making system 1, and an article storage plan in article supply tray 104 (e.g., positions where the articles are stored, the number of article supply trays 104 to be created). The specific article information is not limited to the above, and may also include additional information. Control system 200 may acquire the article information by making an inquiry to host system 300, or passively receive the article information transmitted from host system 300. Alternatively, control system 200 may present a predetermined user interface (UI) screen (not illustrated) to a user via input device 203, and receive an input from the user.

Control system 200 determines the positions where articles are stored, the order in which the articles are discharged from article supply tray 104, operations of robot 106, and the like, based on the article information input in step S1701 (step S1702). The order in which the articles are discharged from article supply tray 104 includes the timing and the amount by which shutter 601 corresponding to each of tray units 103 is opened/closed (the amount by which motor 605 is rotated). The operations of robot 106 include operations for holding and for discharging article storage tray 108, and controls such as adjusting the position of article storage tray 108 to receive an article and to have its image captured by a camera. The various operations determined herein include both of the operations of robot 106 and the operations of tray unit 103.

Control system 200 gives an instruction to robot 106 to hold empty article storage tray 108 being delivered by article storage tray conveyor 110, based on the determinations made in step S1702 (step S1703).

Based on the determinations made in step S1702, control system 200 gives an instruction to robot 106 to move article storage tray 108 held thereby in such a manner that the intended storage section is brought to the position where the article is discharged from article conveyor 102 that is conveying the intended article (step S1704). At this time, because article conveyor 102 may be conveying a plurality of articles, as appropriate, control system 200 also controls the timing for moving article storage tray 108 in such a manner that any article is not stored in a storage section other than the intended storage section, and the article being conveyed does not fall out of article storage tray 108.

Based on the determinations made in step S1702, control system 200 controls the operation of tray unit 103 so that the article is discharged (drops) from the corresponding tray unit 103 onto article conveyor 102 (step S 1705). The operation of tray unit 103 in this step corresponds to the operation described with reference to Fig. 8. Control system 200 may also be configured to stop the conveying operation of article conveyor 102. Control system 200 may stop the conveying operation to prevent the article discharged from tray unit 103 from rolling out of article conveyor 102, for example. Therefore, it is possible to control whether to stop the conveying operation depending on the shape of the article.

Control system 200 controls the operation of article conveyor 102 to convey the article toward the exit (discharge position) (step S 1706).

Control system 200 causes sensor 1301 provided around the exit (discharge position) of article conveyor 102 to detect the passage of the article. In this manner, control system 200 detects that the article has been discharged from article conveyor 102 into article storage tray 108, and received in article storage tray 108 (step S 1707). In other words, through the operations of robot 106 up to step S 1704 and the operations of tray unit 103 up to step S 1706, the intended article is received in the intended storage section of article storage tray 108.

Control system 200 determines whether the storing operation with respect to article storage tray 108 currently being held by robot 106 has been completed based on the determinations made in step S1702 (step S1708). In other words, because one or more of articles are stored in one article storage tray 108, a determination as to whether such articles have been stored is made. If the storing operation has been completed for all of the articles (step S1708; YES), the process goes to step S1709. By contrast, if there is any article not having been stored (step S1708; NO), the process goes back to steps S1704 and S1706, and the operations of robot 106 and tray unit 103 are repeated. Control system 200 may be configured to stop the conveying operation of article conveyor 102 when sensor 1301 detects the passage of an article in step S1708. At this time, the stopping operation may be defined as an operation for ensuring time (the time for which the conveying operation is stopped), when it is necessary to supply another article to the article storage tray 108 currently being held, and to move article storage tray 108 to the position where the article is to be supplied, for example. The stopping operation may also be defined as an operation for ensuring time (the time for which the conveying operation is stopped), when the article storing operation has been completed for article storage tray 108 currently being held, and it is necessary to capture an image of article storage tray 108 and to discharge article storage tray 108, and to hold the next empty article storage tray 108, for example.

Control system 200 checks for a corresponding relationship between the article and the storage section in article storage tray 108 being held (step S1709). In the present exemplary embodiment, control system 200 moves the article storage tray 108 held thereby to the image capturing position of camera 107, and causes camera 107 to capture an image of article storage tray 108. Control system 200 then analyzes the captured image to check the corresponding relationship between the article and the storage section. The correct corresponding relationship is included in the information input in step S 1701.

Control system 200 determines whether the corresponding relationship is correct, based on the result of checking in step S1709 (step S1710). The corresponding relationship being correct means that the correct articles are stored in the correct storage sections in entire article storage tray 108 being held, and such a tray is handled as an OK tray. By contrast, the corresponding relationship not being correct means that at least one of the articles and the storage sections is incorrect in article storage tray 108 being held, and such a tray is handled as an NG tray. If the corresponding relationship is correct (step S1710; YES), the process goes to step S1711. By contrast, if the corresponding relationship is not correct (step S1710; NO), the process goes to step S1712.

Control system 200 then determines that article storage tray 108 held by robot 106 is an OK tray, and controls robot 106 to discharge article storage tray 108 held thereby to OK tray conveyor 109 (step S1711).

Control system 200 then determines that article storage tray 108 held by robot 106 is an NG tray, and controls robot 106 to discharge article storage tray 108 held thereby to NG tray conveyor 111 (step S1712).

Control system 200 then determines whether the storing operations for all of article storage trays 108 have been completed as planned, based on the article information input in step S1701 (step S1713). If the operations have been completed (step S1713; YES), the sequence of this process is ended. By contrast, if the operations have not been completed yet (step S1713; NO), the process goes back to steps S1703 and S1705, and the operations of robot 106 and tray unit 103 are repeated on new article storage tray 108.

### (Operation of robot)

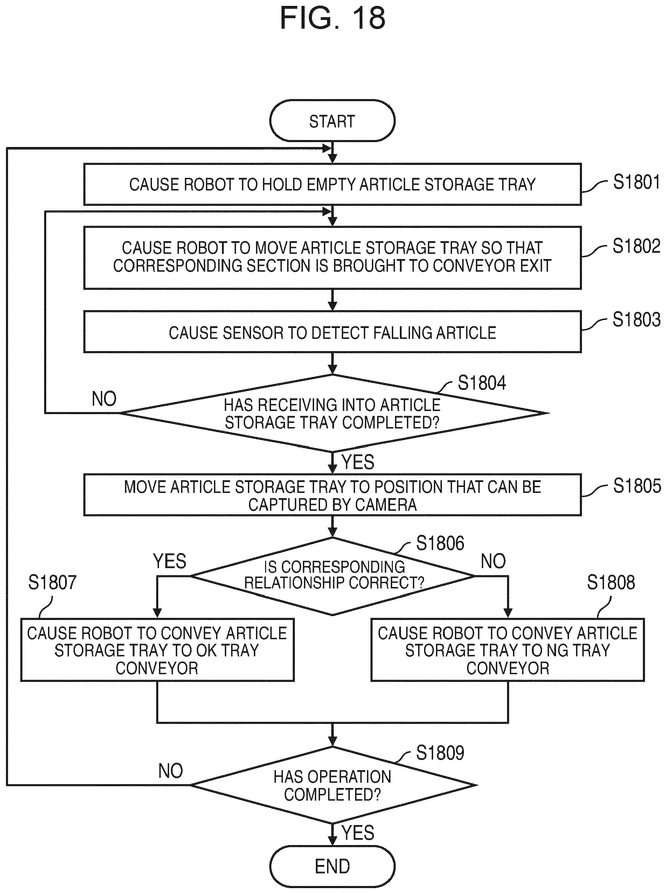

Fig. 18 is a sequence chart of the operation of robot 106, among the operations of the tray making system 1 according to the present exemplary embodiment. This sequence focuses on the operations of robot 106 in the processing sequence illustrated in Fig. 17. The operation of robot 106 is controlled by causing processor 201 in control system 200 to read and to execute various programs stored in the memory 202, and to issue an instruction via robot connector 207.

Robot 106 holds empty article storage tray 108 delivered by article storage tray conveyor 110, based on an instruction from control system 200 (step S1801).

Based on an instruction from control system 200, robot 106 moves article storage tray 108 being held in such a manner that the intended storage section of article storage tray 108 is brought to the position where the article is discharged from article conveyor 102 that is conveying the intended article (step S1802). At this time, because article conveyor 102 may be conveying a plurality of articles, as appropriate, the timing for robot 106 to move article storage tray 108 is controlled in such a manner that any article is not stored in a storage section other than the intended storage section, and the article being conveyed does not fall out of article storage tray 108.

In response to the detection of the passage of the article by sensor 1301, control system 200 determines that the article has been stored in article storage tray 108 (step S1803). Note that through this determination that the article has been stored, robot 106 can proceed to the next article storing operation.

Control system 200 determines whether the storing operations for article storage tray 108 currently being held by robot 106 has been completed, based on the result of the determination made in step S1803 (step S1804). In other words, because a plurality of articles may be stored in one article storage tray 108, control system 200 determines whether all of the articles have been stored. If the storing operations for all of the articles have been completed (step S1804; YES), the process goes to step S1805. By contrast, if there is any article not having been stored yet (step S1804; NO), the process goes back to step S1802, and the operation of robot 106 is repeated.

Robot 106 moves article storage tray 108 being held thereby to the position at which an image is captured by camera 107, based on an instruction from control system 200 (step S1805). An image of article storage tray 108 is then captured by camera 107.

Control system 200 determines whether the corresponding relationship is correct (step S1806). The corresponding relationship being correct means that the correct articles are stored in the correct storage sections in entire article storage tray 108 being held, and such a tray is handled as an OK tray. By contrast, the corresponding relationship not being correct means that at least one of the articles and the storage sections is incorrect in article storage tray 108 being held, and such a tray is handled as an NG tray. If the corresponding relationship is correct (step S1806; YES), the process goes to step S1807. By contrast, if the corresponding relationship is not correct (step S1806; NO), the process goes to step S1808.

Robot 106 determines that article storage tray 108 held thereby is an OK tray, and discharges article storage tray 108 held thereby to the OK tray conveyor 109 (step S1807).

Robot 106 determines that article storage tray 108 held thereby is an NG tray, and discharges article storage tray 108 held thereby to NG tray conveyor 111 (step S1808).

Control system 200 determines whether the storing operations for all of article storage trays 108 have been completed as planned (step S1809). If the process has been completed (step S1809; YES), the sequence of this process is ended. By contrast, if the process has not been completed (step S1809; NO), the process goes back to step S1801, and the operation of robot 106 is repeated on new article storage tray 108.

### (Operation of tray unit)

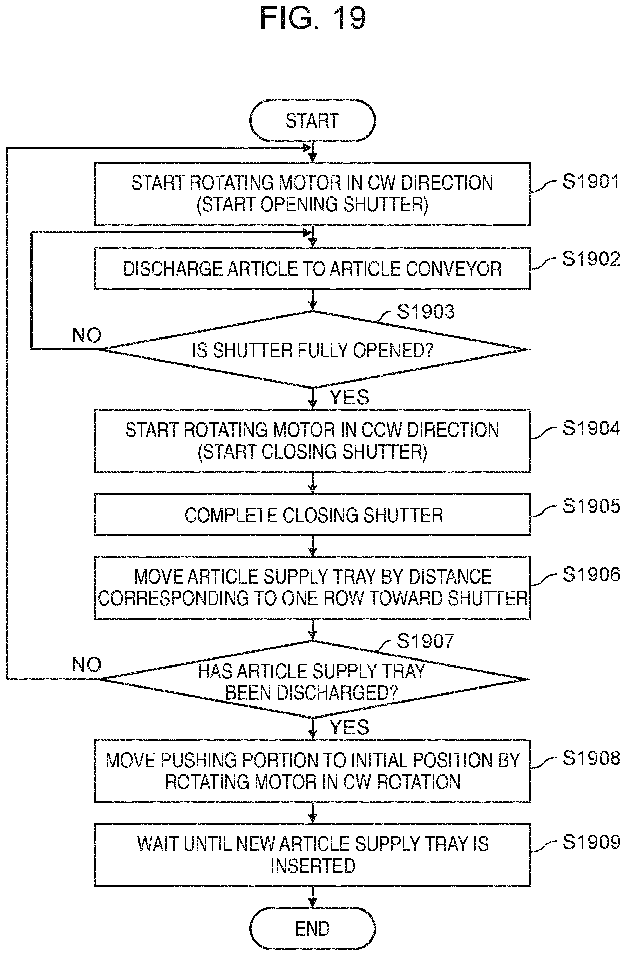

Fig. 19 is a sequence chart of operations of tray unit 103, among those of tray making system 1 according to the present exemplary embodiment. This sequence focuses on the operations of tray unit 103 in the processing sequence illustrated in Fig. 17. As illustrated in Fig. 1, the tray making system 1 includes one or more of tray units 103, and is controlled by causing control system 200 to give an instruction to tray controller 101 corresponding to each tray unit 103. The operations of tray unit 103 is controlled by causing processor 201 in control system 200 to read and to execute various programs stored in the memory 202, and to give an instruction via the tray making unit connector 205. In addition, at the beginning of the sequence of this process, shutter 601 on tray unit 103 is fully closed, and article supply trays 104 storing therein articles are appropriately installed in one or more tray units 103.

Motor 605 in tray unit 103 starts rotating in the CW direction, based on the instruction from tray controller 101 (step S1901). In this manner, an operation for opening shutter 601 on tray unit 103 is started. The amount, the speed, and the timing by and at which the motor is rotated are defined based on factors such as the configuration of article supply tray 104 to be discharged, and the number of times articles are discharged.

Tray unit 103 discharges (drops) articles from article supply tray 104 onto article conveyor 102 as appropriate, in a manner synchronized with opening of shutter 601.

Control system 200 determines whether shutter 601 has been fully opened (step S1903). Shutter 601 being fully open means that the articles stored in one row of article supply tray 104 have been completely supplied. It is possible to determine whether shutter 601 is fully opened by detecting the contact between protrusion 607 provided on shutter 601 and the end of tray unit 103, for example. If shutter 601 is fully opened (step S1903; YES), the process goes to step S1904. By contrast, if shutter 601 has not been fully opened (step S1903; NO), the process goes back to step S1902, and motor 605 is kept rotating in the CW direction.

Motor 605 in tray unit 103 starts rotating in the CCW direction in response to an instruction from tray controller 101 (step S1904). In this manner, the operation for closing shutter 601 on tray unit 103 is started. The rotation speed here may be defined in advance.

Shutter 601 on tray unit 103 becomes fully closed, as motor 605 is kept rotating in the CCW direction (step S1905). This corresponds to the configuration illustrated in part (a) of Fig. 10.

As motor 605 is kept rotating in the CCW direction, pushing portion 602 of tray unit 103 pushes out article supply tray 104 toward shutter 601 by a length corresponding to one row of the storage sections (step S1906). This corresponds to the configuration illustrated in part (b) and part (c) of Fig. 10. The amount pushed by pushing portion 602 is defined based on the configuration of the installed article supply tray 104 (e.g, the size of one row of the storage sections).

Control system 200 determines whether the installed article supply tray 104 has been discharged from tray unit 103 (step S1907). In other words, the articles have been discharged from all the rows of article supply tray 104. As a result, it is determined whether article supply tray 104 has been discharged. This determination may be made based on the configuration information of article supply tray 104 or the number of articles having been discharged, or a sensor or the like may be used to detect whether article supply tray 104 has been discharged. If article supply tray 104 has not been discharged yet (step S1907; NO), that is, if there is any row in which undischarged articles are stored on article supply tray 104, the process goes back to step S1901 and the process is repeated. By contrast, if article supply tray 104 has been discharged (step S1907; NO), the process goes to step S1908.

Motor 605 in tray unit 103 is rotated in the CW direction, based on an instruction from tray controller 101, and moves pushing portion 602 to the initial position (step S 1908). The initial position of pushing portion 602 may be defined in advance, and the amount by which motor 605 is rotated in the CW direction to bring pushing portion 602 to the initial position may also be defined in advance. As a result, tray unit 103 will be as illustrated in part (a) of Fig. 9.

Tray unit 103 is kept standby until new article supply tray 104 filled with articles is installed. New article supply tray 104 is installed in the manner illustrated in part (b) to part (d) of Fig. 9.

Note that even if article supply tray 104 becomes empty in any one of the one or more tray units 103 in the tray making system 1, as long as another tray unit 103 can continue the storing operation for article storage tray 108, the operation of the entire system may be continued by keeping only the operations of empty tray unit 103 standby.

As described above, according to the present exemplary embodiment, tray making unit 100 in the tray making system 1 includes article supply tray holding unit 603 that holds article supply tray 104 storing therein articles, opening 603a provided in article supply tray holding unit 603, openable shutter 601 provided to opening 603a, rotation shaft 604 that drives to open and to close shutter 601, motor 605, drum 606, and article conveyor 102 provided below opening 603a. Article supply tray holding unit 603 holds article supply tray 104 in such a manner that an article stored in article supply tray 104 is discharged onto article conveyor 102 through opening 603a when shutter 601 is opened. Rotation shaft 604, motor 605, and drum 606 control opening and closing of shutter 601 based on the size of article storage sections 401 in article supply tray 104. In an automated system for achieving an intended article storage condition, it is possible to supply an article to be stored more efficiently, and to further improve the operation efficiency.

In addition, motor 605 controls opening and closing of shutter 601 based on the size of the plurality of storage sections 401 in article supply tray 104, the size being a size in the direction in which shutter 601 is opened and closed (+X direction and -X direction in Fig. 6). As a result, it is possible to control to supply articles by opening shutter 601 based on the size of the storage sections, the size being a size in the direction in which shutter is opened and closed, with respect to the plurality of articles storage sections included in article supply tray 104.

Tray making unit 100 further includes pushing portion 602 that moves article supply tray 104, and pushing portion 602 moves article supply tray 104 held by article supply tray holding unit 603 from the side of pushing portion 602 toward opening 603a. As a result, article supply tray 104 can be moved toward opening 603a in units of one row of storage sections that are arranged in the direction in which the shutter is opened or closed, with respect to the plurality of article storage sections included in article supply tray 104.

In tray making unit 100, the direction in which shutter 601 is opened or closed is orthogonal to the direction in which article supply tray 104 is moved by pushing portion 602 (-Z direction in Fig. 6). As a result, article supply tray 104 can be moved orthogonally to the direction in which shutter 601 is opened or closed

Furthermore, pushing portion 602 moves article supply tray 104 based on the size of the plurality of storage sections included in article supply tray 104, the size being a size in the direction in which pushing portion 602 moves. As a result, article supply tray 104 can be moved toward opening 603a, based on the shape of each of the plurality of article storage sections included in article supply tray 104.

Furthermore, pushing portion 602 moves article supply tray 104 toward the opening when shutter 601 is fully closed. As a result, article supply tray 104 can be moved toward the opening without dropping the article in article supply tray 104.

Furthermore, in tray making unit 100, motor 605 causes the rotation shaft 604 to rotate so as to open or close shutter 601, and to cause pushing portion 602 to operate. After rotation shaft 604 is rotated in the CW direction to open shutter 601, the rotation shaft 604 is rotated in the CCW direction to close shutter 601. Once shutter 601 is fully closed, pushing portion 602 is caused to move article supply tray 104 toward opening 603a. As a result, one motor 605 can be used in the control for opening and closing shutter 601 and for causing the pushing portion 602 to make the pushing operation. Therefore, it is possible to simplify the structure. In addition, supplying of an article can be easily controlled.

Furthermore, tray unit 103 includes an insertion portion into which article supply tray 104 is inserted. Pushing portion 602 includes support 602a and inclined portion 602b supported by support 602a. Inclined portion 602b is inclined in a direction in which the distance between inclined portion 602b and the bottom surface of article supply tray holding unit 603 increases from the side of opening 603a toward the insertion portion. As a result, it is possible to achieve a configuration in which article supply tray 104 can be easily inserted into tray unit 103, and article supply tray 104 can be easily moved inside tray making unit 100.

### <Other exemplary embodiments>

Another possible implementation includes processing in which a program and an application for implementing the functions according to the one or more exemplary embodiments described above are supplied to a system or an apparatus, by using a network, a storage medium, or the like, and one or more processors in a computer included in the system or the apparatus are caused to read and execute the program and the application.

Alternatively, the embodiment may be implemented as a circuit (for example, an application specific integrated circuit (ASIC) or a field programmable gate array (FPGA)) that implements one or more functions.

Furthermore, the functions described above may be configured on a network using a cloud computing technology. In this case, a terminal device can use the various functions described above over the network.

Although various exemplary embodiments have been described above with reference to the drawings, it goes without saying that the present disclosure is not limited to such examples. It is obvious that those skilled in the art can arrive at various modification examples, modification examples, replacement examples, additional examples, deletion examples, and equivalent examples within the scope described in the claims, and it is understood that these examples naturally belong to the technical scope of the present disclosure. In addition, the elements included in the various exemplary embodiments described above may be combined in any way, within the scope not departing from the gist of the present disclosure.

The present disclosure is useful in an automated system capable of improving the efficiency at which articles to be stored are supplied, and of further improving the operation efficiency.

## Claims

1. An article supply device comprising:
a holding unit that holds an article supply tray having a storage section;
an opening that is provided in the holding unit;
a shutter that is provided in the opening, the shutter being configured to be opened and closed;
a drive unit that drives the shutter; and
an article reception portion that is provided below the opening,
wherein the holding unit holds the article supply tray such that an article stored in the storage section of the article supply tray is discharged to the article reception portion through the opening when the shutter is opened, and
the drive unit controls opening and closing of the shutter based on a size of the storage section.

2. The article supply device according to Claim 1, wherein
the article supply tray has a plurality of the storage sections in a direction in which the shutter is opened and closed, and
the drive unit controls opening and closing of the shutter based on a size of the plurality of storage sections.

3. The article supply device according to Claim 1, further comprising a movement portion that moves the article supply tray,
wherein the movement portion moves the article supply tray held by the holding unit toward the opening.

4. The article supply device according to Claim 3, wherein directions in which the shutter is opened and closed are orthogonal to a moving direction of the article supply tray moved by the movement portion.

5. The article supply device according to Claim 4, wherein
the article supply tray has a plurality of the storage sections in the moving direction, and
the movement portion moves the article supply tray based on a size of the plurality of storage sections.

6. The article supply device according to any one of Claims 3 to 5, wherein the movement portion moves the article supply tray toward the opening while the shutter is closed.

7. The article supply device according to any one of Claims 3 to 6, wherein
the drive unit includes a motor and a rotation shaft,
the drive unit controls opening and closing of the shutter and moves the movement portion by causing the motor to rotate the rotation shaft,
the shutter is opened by rotation of the rotation shaft in a first rotation direction,
the shutter is closed by rotation of the rotation shaft in a second rotation direction that is reverse to the first rotation direction, and
the movement portion moves the article supply tray toward the opening after the shutter is closed.

8. The article supply device according to any one of Claims 3 to 7, wherein
the holding unit includes an insertion portion into which the article supply tray is inserted,
the movement portion includes
a support, and
an inclined portion supported by the support, and
the inclined portion is provided such that a distance between the inclined portion and a bottom surface of the holding unit increases from the opening toward the insertion portion.
